# EUROPÄISCHE PATENTANMELDUNG

(11) **EP 2 768 290 A1**
(43) Veröffentlichungstag der Anmeldung: **20.08.2014**
(21) Anmeldenummer: 13199243.0
(22) Anmeldetag: 20.12.2013
(51) Int. Cl.: H05K 1/18, F21S 4/00, H05K 3/00

(54) **Elektronisches Bauteil**

(30) Priorität: 19.02.2013 DE 102013101644
(71) Anmelder: SUMIDA flexible connections GmbH, 01454 Radeberg (DE)
(72) Erfinder: Röder, Jürgen, 34393 Grebenstein (DE)
(74) Vertreter: Riechelmann & Carlsohn Patentanwälte

(57) **Zusammenfassung**

Die Erfindung betrifft ein elektronisches Bauteil mit einem Träger (14), einem oder mehreren elektronischen Bauelementen (8) und einem Flachleiterkabel (2), das zumindest zwei parallel zueinander verlaufende Flachleiter (3) aus einem elektrisch leitfähigen Material aufweist, die zwischen einer ersten Kunststofffolie (4) und einer zweiten Kunststofffolie (5) angeordnet sind und mittels zumindest einer Klebstoffschicht (11, 12) mit diesen verklebt sind, wobei in der ersten Kunststofffolie (4) erste Aussparungen (6) unter Ausbildung freiliegender Bereiche (7) der Flachleiter (3) ausgebildet sind, auf die die elektronischen Bauelemente (8) montiert sind. Dabei ist vorgesehen, dass das Flachleiterkabel (2) mit seiner zweiten Kunststofffolie (5) auf dem Träger (14) aufliegt, wobei in der zweiten Kunststofffolie (5) zweite Aussparungen (9) unter Ausbildung freiliegender Bereiche (13) der zumindest einen Klebstoffschicht (11, 12) ausgebildet sind, über die das Flachleiterkabel (2) mit dem Träger (14) verklebt ist.

## Beschreibung

Die Erfindung betrifft ein elektronisches Bauteil und ein Verfahren zur Herstellung eines elektronischen Bauteils. Sie betrifft insbesondere ein Leuchtmittel und ein Verfahren zur Herstellung eines Leuchtmittels.

Aus DE 10 2010 060 344 A1 ist ein SMD-bestücktes Folienband bekannt, das zumindest zwei parallel zueinander verlaufende Flachleiter aus einem elektrisch leitfähigen Material und eine Kunststofffolie umfasst. Die Flachleiter sollen mit ihren ersten Breitseiten und voneinander beabstandet auf einer Flächenseite der Kunststofffolie angeordnet sein, während auf die zweiten Breitseiten der Flachleiter die SMD-Bauelemente aufgebracht sind. Jedes SMD-Bauelement soll zwei Flachleiter kontaktieren. Die SMD-Elemente können Leuchtdioden (LEDs) sein. Das Folienband umfasst eine Klebstoffschicht, die die Leiterbahnen mit der Kunststofffolie verklebt.

Es hat sich nun herausgestellt, dass beim Einsatz derartiger Folienbänder ein fester Träger vorteilhaft sein kann, auf den das Folienband aufgebracht ist.

Aufgabe der Erfindung ist es, ein elektronisches Bauteil anzugeben, das von einem Träger getragen wird und das unter Verwendung eines elektronische Bauelemente tragenden Flachleiterkabels mit möglichst geringem Aufwand und Materialeinsatz hergestellt werden kann.

Diese Aufgabe wird durch die Merkmale der Ansprüche 1, 6 und 7 gelöst. Zweckmäßige Ausgestaltungen der Erfindungen ergeben sich aus den Merkmalen der Unteransprüche.

Nach Maßgabe der Erfindung ist ein elektronisches Bauteil vorgesehen, das einen Träger, ein oder mehrere elektronische Bauelemente und ein Flachleiterkabel aufweist. Das Flachleiterkabel weist zumindest zwei parallel zueinander verlaufende Flachleiter aus einem elektrisch leitfähigen Material auf, die zwischen einer ersten Kunststofffolie und einer zweiten Kunststofffolie angeordnet sind und mittels zumindest einer Klebstoffschicht mit diesen verklebt sind. In der ersten Kunststofffolie sind erste Aussparungen unter Ausbildung freiliegender Bereiche der Flachleiter ausgebildet, auf die die elektronischen Bauelemente montiert sind. Das Flachleiterkabel liegt mit seiner zweiten Kunststofffolie auf dem Träger auf, wobei in der zweiten Kunststofffolie zweite Aussparungen unter Ausbildung freiliegender Bereiche der zumindest einen Klebstoffschicht ausgebildet sind, über die das Flachleiterkabel mit dem Träger verklebt ist.

Das erfindungsgemäße elektronische Bauteil ermöglicht es, das Flachleiterkabel auf dem Träger mittels der Klebstoffschicht zu befestigen, die zum Verkleben der beiden Kunststofffolien und Flachleiter ohnehin vorhanden ist. Es ist also keine weitere Klebstoffschicht erforderlich, die auf die Oberseite des Trägers oder auf die Unterseite der zweiten Kunststofffolie, also die Seite der zweiten Kunststofffolie, die den Flachleitern abgewandt ist, aufgebracht werden müsste. Es hat sich herausgestellt, dass es ausreichend ist, Abschnitte der zweiten Kunststofffolie zu entfernen - wodurch die zweiten Aussparungen entstehen -, so dass Bereiche der Klebstoffschicht, die zum Verkleben der Kunststofffolien und der Flachleiter dient, freiliegen, und die freiliegenden Bereiche der Klebstoffschicht zu nutzen, um eine sichere und dauerhafte Klebverbindung zwischen dem Flachleiterkabel und dem Träger herzustellen. Das ist mit einer Einsparung von Arbeitsgängen und einer Materialeinsparung verbunden.

Zweckmäßigerweise sind die zweiten Aussparungen an den Längskanten der zweiten Kunststofffolie ausgebildet. Vorzugsweise sind an beiden Längskanten der zweiten Kunststofffolie zweite Aussparungen ausgebildet. Vorzugsweise liegen sich an beiden Längskanten Aussparungen gegenüber. Ebenso bevorzugt sind die Aussparungen äquidistant zueinander, bezogen auf die Längsrichtung des Flachleiterkabels, angeordnet. Die zweiten Aussparungen sollten nicht unmittelbar an den Stirnseiten des Flachleiterkabels beginnen, sondern von diesen beabstandet sein.

Vorzugsweise weist das Flachleiterkabel zumindest zwei, stärker bevorzugt zumindest drei, noch stärker bevorzugt zumindest vier zweite Aussparungen an jeder der beiden Längskanten des Flachleiterkabels auf.

Die zweiten Aussparungen erstrecken sich vorzugsweise von der Längskante in Breitenrichtung des Flachleiterkabels in Richtung der Flachleiterkabel, aber nicht bis zu diesen. Die zweiten Aussparungen legen die Flachleiter nicht, auch nicht bereichsweise, frei. Damit ist sichergestellt, dass die Flachleiter nicht in Kontakt mit dem Träger gelangen. Vielmehr befindet sich zwischen der Oberfläche des Trägers und der Breitseite der Flachleiter, die dieser Oberfläche zugewandt ist, die zweite Kunststofffolie.

Die ersten Aussparungen können sich hingegen über die gesamte Breite der ersten Kunststofffolie erstrecken. In diesem Falle besteht die erste Kunststofffolie aus voneinander beabstandeten Streifen, die quer zur Längsrichtung des Flachleiterkabels verlaufen. Dabei liegen Bereiche aller Flachleiterkabel frei, auf die die elektronischen Bauelemente montiert werden können. Die ersten Aussparungen sind vorzugsweise äquidistant zueinander, bezogen auf die Längsrichtung des Flachleiterkabels, angeordnet. Die ersten Aussparungen sollten nicht unmittelbar an den Stirnseiten des Flachleiterkabels beginnen, sondern von diesen beabstandet sein.

Vorzugsweise weist das Flachleiterkabel zumindest eine, stärker bevorzugt zumindest zwei, noch stärker bevorzugt zumindest drei erste Aussparungen auf. Die Zahl der ersten Aussparungen wird durch die Zahl der elektronischen Bauelemente bestimmt, die auf dem Flachleiterkabel montiert werden sollen. Bei einem Flachleiterkabel mit zwei Flachleitern können beispielsweise drei erste Aussparungen vorgesehen sein, wobei drei elektronische Bauelemente, beispielsweise drei Leuchtdioden, an den dann drei freiliegenden Bereichen der Flachleiter montiert sind.

Damit die Stabilität des Flachleiterkabels erhalten bleibt, kann vorgesehen sein, dass die zweiten Aussparungen in der zweiten Kunststofffolie zwischen benachbarten ersten Aussparungen in der ersten Kunststofffolie ausgebildet sind. Die ersten Aussparungen sollten den zweiten Aussparungen nicht gegenüberliegen.

Die erste und zweite Kunststofffolie sind vorzugsweise bahn- oder streifenförmig. Vorzugsweise bestehen sie, unabhängig voneinander, aus handelsüblichen Materialien, wie sie im Stand der Technik für die Herstellung von FFCs (engl. für "flat flex cables, dt. Flachbandkabeln) bekannt sind. Bevorzugte Materialien sind Polyethylenterephthalat (PET), Polyaramidpapier, Polyethylennaphthalat (PEN), Polyamid (PA) oder Polyimid (PI), wobei Polyethylenterephthalat oder Polyaramidpapier besonders bevorzugt ist. Polyaramaidpapier ist beispielsweise unter dem Handelzeichen "Nomex" kommerziell erhältlich. Die Dicke der Kunststofffolien beträgt vorzugsweise 10 oder mehr Mikrometer. Vorzugsweise haben die erste und zweite Kunststofffolie die gleichen Dimensionen und bestehen aus dem gleichen Material.

Die Flachleiter sind vorzugsweise Leiterbahnen. Vorzugsweise bestehen sie aus Kupfer oder Aluminium, wobei Kupfer bevorzugt ist. Der Abstand zwischen zwei benachbarten Flachleitern wird vorzugsweise in Abhängigkeit von der Ausdehnung des Widerstandes in Querrichtung zur Längsrichtung der Flachleiter bestimmt. Die Flachleiter haben vorzugsweise einen in etwa rechteckigen Querschnitt. Der Ausdruck "in etwa rechteckiger Querschnitt" der Flachleiter soll sowohl Flachleiter mit rechteckigem Querschnitt als auch Flachleiter mit einem Querschnitt bezeichnen, der von einem idealen rechteckigen Querschnitt abweicht, indem er beispielsweise abgerundete Ecken besitzt. Die Dicke der Flachleiter beträgt vorzugsweise 10 oder mehr Mikrometer. Die Flachleiter sind vorzugsweise von den Längsrändern der Kunststofffolie beabstandet. Vorzugsweise haben die Flachleiter dieselben Dimensionen und bestehen aus demselben Material, dies ist jedoch nicht erforderlich. Die Flachleiter können an einer Stirnseite des Flachleiterkabels freiliegen, um eine Stromversorgung der Flachleiter zu vereinfachen.

Bei dem Klebstoff der Klebstoffschicht(en) handelt es sich vorzugsweise um einen Schmelzklebstoff oder einen Permanentklebstoff. Es können bekannte handelsübliche Schmelzklebstoffe bzw. Permanentklebstoffe eingesetzt werden. Bei dem Schmelzklebstoff kann es sich um eine klebende Masse auf Basis von Polyethylen, Polyester-Elastomeren, Polyurethan-Elastomeren und/oder Ethylenvinylacetat-Copolymeren handeln. Bei dem Permanentklebstoff kann es sich um eine klebende Masse auf Acrylatbasis handeln. Die Dicke der Klebstoffschicht liegt vorzugsweise zwischen 10 und 80 Mikrometer. Vorzugsweise wird die Klebstoffschicht vollflächig auf eine Flächenseite der Kunststofffolie aufgebracht, dies ist jedoch nicht erforderlich.

In einer Ausführungsform der Erfindung sind zwei Klebstoffschichten vorgesehen. Dabei ist eine erste Klebstoffschicht auf die Flächenseite der ersten Kunststofffolie aufgebracht, die den Breitseiten der Flachleiter zugewandt ist. Die zweite Klebstoffschicht ist auf die Flächenseite der zweiten Kunststofffolie aufgebracht, die den Breitseiten der Flachleiter zugewandt ist. Die ersten Aussparungen in der ersten Kunststoffschicht können beispielsweise durch Stanzen erhalten werden. Dabei werden neben Abschnitten der ersten Kunststofffolie auch die darauf aufgebrachten Abschnitte der ersten Klebstoffschicht entfernt. Die zweiten Aussparungen in der zweiten Kunststofffolie können ebenfalls durch Stanzen erhalten werden. Dabei werden neben Abschnitten der zweiten Kunststofffolie auch die darauf aufgebrachten Abschnitte der zweiten Klebstoffschicht entfernt.

Ist nur eine Klebstoffschicht vorgesehen, so ist diese Klebstoffschicht vorzugsweise auf der Flächenseite der ersten Kunststofffolie aufgebracht, die den Breitseiten der Flachleiter zugewandt ist. Die ersten Aussparungen in der ersten Kunststofffolie können beispielsweise durch Stanzen erhalten werden. Dabei werden neben Abschnitten der ersten Kunststofffolie auch die darauf aufgebrachten Abschnitte der Klebstoffschicht entfernt.

Die Dicke und Breite der Kunststofffolien, der Flachleiter und der zumindest einen Klebstoffschicht kann der Fachmann beispielsweise auf Basis seiner Kenntnis aus der Herstellung von FFC (engl. für "flat flex cable, dt. Flachbandkabel) bestimmen.

Der Träger ist vorzugsweise ein plattenförmiges Bauteil. Der Träger weist vorzugsweise eine flache oder gewölbte Fläche auf, auf die das Flachleiterkabel aufgebracht ist. Das Bauteil kann beispielsweise eine Platte aus Kunststoff, Metall, Keramik oder Holz sein. Der Träger weist vorzugsweise eine Stärke von 1 mm oder mehr auf. Die Breite des Trägers sollte der Breite des Flachleiterkabels entsprechen. Die Länge des Trägers sollte der Länge des Flachleiterkabels entsprechen. Der Träger ist vorzugsweise starr. Der Träger besitzt vorzugsweise eine höhere Steifigkeit als das Flachleiterkabel.

Die erfindungsgemäß vorgesehenen elektronischen Bauelemente sind vorzugsweise aus der Gruppe gewählt, die Widerstände, Kondensatoren, Quarze, Dioden wie Leuchtdioden, Transistoren und Spulen sowie Kombinationen davon, umfasst. Die elektronischen Bauelemente werden über die Flachleiter mit Strom versorgt.

Die elektronischen Bauelemente sind vorzugsweise SMD-Bauelemente (SMD: engl. für "surface-mounted device", deutsch: oberflächenmontiertes Bauelement). Die SMD-Bauelemente können in jeder beliebigen Bauform eingesetzt werden, beispielsweise in zylinderförmiger oder quaderförmiger Bauform, wobei die zylinderförmige Bauform bevorzugt ist. Die Stirnseiten der erfindungsgemäß vorgesehenen SMD-Bauelemente sind vorzugsweise als Kontakte ausgebildet. Anschlussdrähte zum Verbinden der SMD-Bauelemente mit den Flachleitern sind daher nicht erforderlich. Aus diesem Grunde sollte der Abstand zwischen den Schmalseiten benachbarter Flachleiter so gewählt werden, dass das SMD-Bauelement, das diese beiden Flachleiter kontaktiert, in Kontakt mit den Breitseiten der beiden Flachleiter in deren freiliegenden Bereichen steht.

Vorzugsweise ist zumindest eines der elektronischen Bauelemente des erfindungsgemäßen elektronischen Bauteils eine Leuchtdiode (LED), bevorzugte eine SMD-Leuchtdiode. In einer Ausführungsform des erfindungsgemäßen Bauteils sind alle elektronischen Bauelemente Leuchtdioden, bevorzugt SMD-Leuchtdioden. Umfasst das erfindungsgemäße Bauteil zumindest eine Leuchtdiode, so kann das erfindungsgemäße elektronische Bauteil als Leuchtmittel eingesetzt werden. Werden die Flachleiter mit Strom versorgt, so wandeln die LEDs die über die Flachleiter zugeführte elektrische Energie in Licht um. Dieses Licht kann dann zum Beleuchten genutzt werden.

Es kann ein Schutzlack zur Oberflächenversiegelung auf freiliegende Bereiche der Flachleiter, die nicht von den elektronischen Bauelementen bedeckt werden, aufgebracht werden.

Das erfindungsgemäße elektronische Bauteil ist, sofern es zumindest eine Leuchtdiode umfasst, insbesondere als Ersatz für Leuchtstoffröhren geeignet.

Ein "freiliegender Bereich" kann von dem Träger oder einem Bauelement bedeckt sein. Vorzugsweise sind die freiliegenden Bereiche der Flachleiter weder von einer der Kunststofffolien noch von einer der Klebstoffschichten bedeckt, während freiliegende Bereiche der Klebstoffschicht nicht von einer der Kunststofffolien bedeckt sein sollten. Die zweiten Aussparungen sollten keine Bereiche der Klebstoffschicht betreffen, die sich in Kontakt mit den Fachleitern befinden.

Nach Maßgabe der Erfindung ist ferner ein Flachleiterkabel vorgesehen, das zumindest zwei parallel zueinander verlaufende Flachleiter aus einem elektrisch leitfähigen Material aufweist, die zwischen einer ersten Kunststofffolie und einer zweiten Kunststofffolie angeordnet sind und mittels zumindest einer Klebstoffschicht mit diesen verklebt sind, wobei in der ersten Kunststofffolie erste Aussparungen unter Ausbildung freiliegender Bereiche der Flachleiter ausgebildet sind, auf die elektronische Bauelemente montiert sind, dadurch gekennzeichnet, dass das Flachleiterkabel mit seiner zweiten Kunststofffolie auf dem Träger aufliegt, wobei in der zweiten Kunststofffolie zweite Aussparungen unter Ausbildung freiliegender Bereiche der zumindest einen Klebstoffschicht ausgebildet sind, über die das Flachleiterkabel mit dem Träger verklebt ist. Die ersten Aussparungen in der ersten Kunststofffolie können daher für die Montage elektronischer Bauelemente bestimmt sein. Die zweiten Aussparungen in der zweiten Kunststofffolie legen die Flachleiter nicht frei und können zum Verkleben des Flachleiterkabels mit einem Träger bestimmt sein.

Das erfindungsgemäße Flachleiterkabel weist die Merkmale des oben, im Zusammenhang mit dem erfindungsgemäßen elektronischen Bauteil beschriebenen Flachleiterkabels auf.

Das erfindungsgemäße Flachleiterkabel kann vorab als Bandware hergestellt, dann abgelängt und mit einem Träger verklebt werden.

Nach Maßgabe der Erfindung ist ferner ein Verfahren vorgesehen, das insbesondere zur Herstellung des erfindungsgemäßen elektronischen Bauteils geeignet ist. Dabei wird ein Flachleiterkabel mittels einer zwischen der ersten und zweiten Kunststofffolie befindlichen Klebstoffschicht über die zweiten Aussparungen in der zweiten Kunststofffolie mit einem Träger verklebt.

In einer bevorzugten Ausführungsform des erfindungsgemäßen Verfahrens sind folgende Schritte vorgesehen:
(a) Bereitstellen einer ersten Kunststofffolie, die mit einer ersten Klebstoffschicht beschichtet ist, und Einbringen von Fenstern für die ersten Aussparungen (6) in die erste Kunststofffolie (4);
(b) Bereitstellen einer zweiten Kunststofffolie, die mit einer zweiten Klebstoffschicht beschichtet ist, und Einbringen von Fenstern für die zweiten Aussparungen (9) in die zweite Kunststofffolie (5),
(c) Anordnen von Flachleitern (3) zwischen der ersten und der zweite Kunststofffolie (4, 5), wobei die erste und zweite Klebstoffschicht (11, 12) einander zugewandt sind, und Verkleben der beiden Kunststofffolien (4, 5) unter Bildung eines Flachleiterkabels (2); und
(d) Aufbringen des Flachleiterkabels auf den Träger, so dass die zweite Kunststofffolie auf dem Träger aufliegt, unter Herstellen einer Klebverbindung zwischen dem Träger und dem Flachleiterkabel.

Das erfindungsgemäße Verfahren kann die Montage von elektronischen Bauelementen auf die freiliegenden Bereiche der Flachleiter umfassen. Dies geschieht vorzugsweise im Anschluss an Schritt (c) oder im Anschluss an Schritt (d).

Die Reihenfolge der Schritte (a) und (b) kann vertauscht werden. Werden Fenster, wie in den Schritten (a) und (b) vorgesehen, in eine Kunststofffolie eingebracht, so wird damit auch ein Teil der Klebstoffschicht entfernt, die auf diese Kunststofffolie aufgebracht ist.

Schritt (c) kann ferner das Beschneiden der verklebten Kunststofffolien an ihren Längsrändern unter Ausbildung der ersten und zweiten Aussparungen umfassen. Auf diese Weise können Aussparungen erhalten werden, die an den Längskanten des Flachleiterkabels liegen. Würden diese Aussparungen bereits in Schritt (a) oder (b) an den Längskanten der Kunststofffolien ausgebildet werden, so könnte dies die Integrität der Kunststofffolien beeinträchtigen. Der Ausdruck "Fenster" bezieht sich dabei auf Aussparungen in den Kunststofffolien, die nicht an deren Längsrändern liegen. Erst durch Beschneiden der verklebten Kunststofffolien werden dann Aussparungen erhalten, die an den Längsrändern der Kunststofffolien liegen können. Durch das Zuschneiden können mehrere Flachleiterkabel aus zwei miteinander verklebten Kunststofffolien gewonnen werden.

Zur Herstellung der Klebverbindung kann Schritt (d) ferner das Erwärmen des Flachleiterkabels zur Verflüssigung des Klebstoffes, der sich zwischen den beiden Kunststofffolien befindet, umfassen. Dies ist insbesondere zweckmäßig, wenn es sich um einen Schmelzklebstoff handelt. Beispielsweise kann das Flachleiterkabel auf eine Temperatur von 120 bis 200 °C, bevorzugt 130 bis 150 °C erwärmt werden, wobei die gewählte Temperatur von der Schmelztemperatur des verwendeten Klebstoffes abhängt. Der verflüssigte Klebstoff verfestigt sich dann unter Ausbildung einer Klebverbindung zwischen dem Träger und dem Flachleiterkabel, und zwar an den zweiten Aussparungen in der zweiten Kunststofffolie, weil an diesen zweiten Aussparungen Teile der Klebstoffschicht der ersten Kunststofffolie freiliegen. Zur Verflüssigung des Klebstoffes kann beispielsweise ein heißer Stempel oder eine erwärmte rotierende Walze eingesetzt werden, die zum einen das Flachleiterkabel auf die Oberfläche des Trägers presst und dabei zum anderen den Klebstoff des Flachleiterkabels erwärmen. Ist der Klebstoff ein Permanentklebstoff ist ein Erwärmen nicht erforderlich.

Zur Herstellung des Kontaktes zwischen den freiliegenden Bereichen der Flachleiter und den SMD-Bauelementen sind vorzugsweise Kontaktelemente aus einem elektrisch leitfähigen Material auf die freiliegenden Bereiche der Flachleiter aufgebracht. Zu diesem Zweck können auf die freiliegenden Bereiche der Flachleiter Lotdepots aufgebracht werden, die beim Verlöten einen Stoffschluss zwischen den Flachleitern und den Kontakten der SMD-Bauelemente herstellen. Die Lotdepots können beispielsweise aus der Gruppe ausgewählt sein, die Zinnlote, Silberlote, Messinglote und Phosphorlote umfasst, wobei Zinnlote bevorzugt sind. Die Lotdepots können mittels bekannter Verfahren wie Siebdruck oder Dispensieren auf die zweiten Breitseiten der Flachleiter, d.h. die Breitseiten, die der Kunststofffolie abgewandt sind, aufgebracht werden. Die SMD-Bauelemente sind vorzugsweise in einer Richtung quer zu den beiden Längsachsen der Flachleiter, die sie kontaktieren, angeordnet.

Die Erfindung wird nachstehend anhand von Ausführungsbeispielen, die die Erfindung nicht einschränken sollen, unter Bezugnahme auf die Zeichnungen näher erläutert. Dabei zeigen
- Fig. 1: eine perspektivische Darstellung einer Ausführungsform des erfindungsgemäßen elektronischen Bauteils von oben, wobei zur Vereinfachung der Darstellung der Träger und die Klebstoffschichten nicht gezeigt sind;
- Fig. 2: eine perspektivische Darstellung der in Fig. 1 gezeigten Ausführungsform des erfindungsgemäßen elektronischen Bauteils von unten, wobei zur Vereinfachung der Darstellung der Träger und die Klebstoffschichten nicht gezeigt sind;
- Fig. 3: eine schematische Querschnittsdarstellung der in Fig. 1 gezeigten Ausführungsform des erfindungsgemäßen elektronischen Bauteils entlang Schnittlinie A--A unter Darstellung des Trägers;
- Fig. 4: eine schematische Querschnittsdarstellung der in Fig. 1 gezeigten Ausführungsform des erfindungsgemäßen elektronischen Bauteils entlang Schnittlinie B--B unter Darstellung des Trägers; und
- Fig. 5: schematische Darstellungen zur Veranschaulichung eines Herstellungsverfahrens für die erfindungsgemäß vorgesehenen Flachleiterkabel (a: Draufsicht auf die erste Kunststofffolie; b: Draufsicht auf die zweite Kunststofffolie; c: Draufsicht auf die verklebten Kunststofffolien; d: Draufsicht auf die verklebten Kunststofffolien nach dem Zuschneiden).

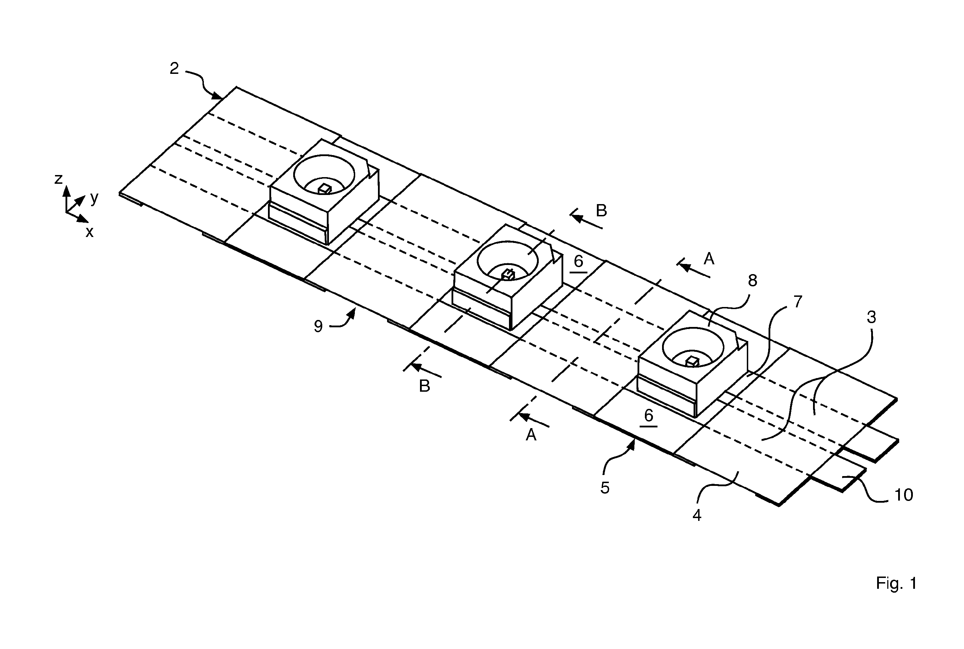

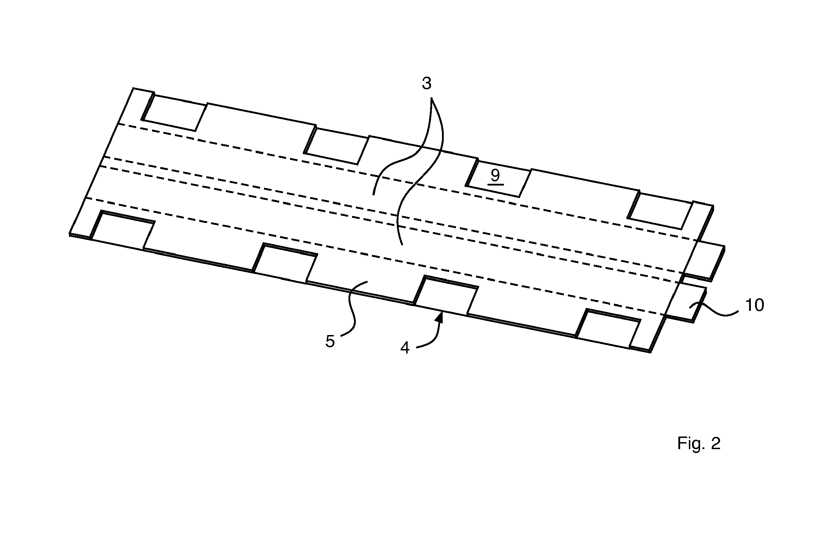

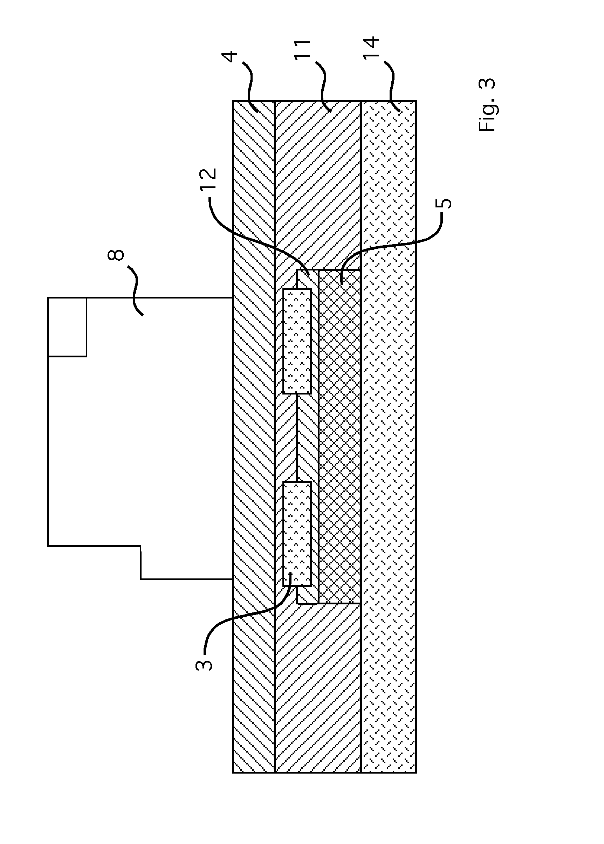

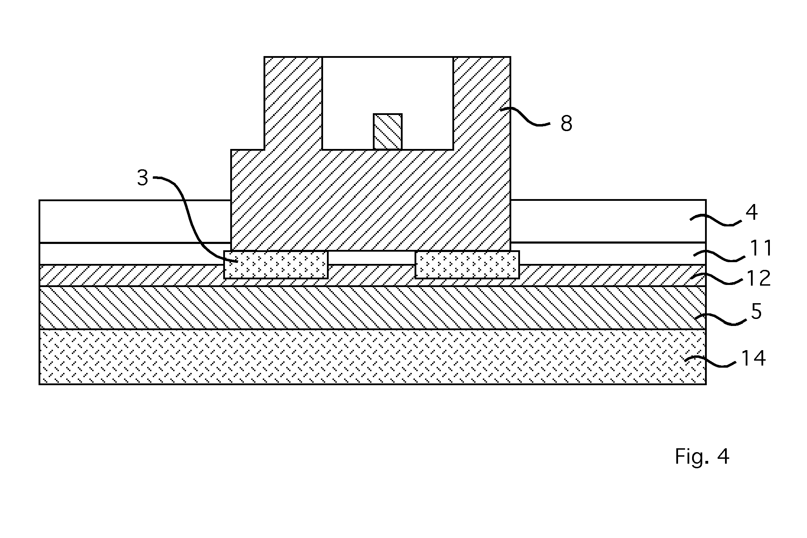

Die in den Figuren 1 bis 4 gezeigte Ausführungsform des erfindungsgemäßen elektronischen Bauteils ist ein Leuchtmittel 1, das drei SMD-Leuchtdioden 8 als elektronische Bauelemente umfasst. Das Leuchtmittel 1weist ein Flachleiterkabel 2 (siehe insbesondere Figuren 1 und 2) auf, das auf einem Träger 14 (siehe insbesondere Figuren 3 und 4) aufliegt. Die Querschnittsdarstellungen in den Figuren 3 und 4 sind nur Prinzipskizzen, die keine Rückschlüsse auf die Dimensionen der Bestandteile des Leuchtmittels 1, insbesondere auf die Stärken der Folien, Schichten und Leiter und Stärkenverhältnisse untereinander zu lassen.

Das erfindungsgemäß vorgesehene Flachleiterkabel 2 umfasst zwei Flachleiter 3, die zwischen einer ersten Kunststofffolie 4 und einer zweiten Kunststofffolie 5 liegen. Die Flachleiter 3 sind voneinander und von den Längsrändern des Flachleiterkabels 2 beabstandet. An einer Stirnseite des Flachleiterkabels 2 liegen die Flachleiter 3 unter Ausbildung von Kontakten 10 für eine Stromversorgung frei. Die Längsachsen der Flachleiter 3 verlaufen parallel zur Längsrichtung (x-Richtung) des Flachleiterkabels 2. Die y-Koordinate zeigt die Breitenrichtung des Flachleiterkabels 2, die z-Koordinate die Stärken- oder Dickenrichtung des Flachleiterkabels 2.

Die erste Kunststofffolie 4 ist mit einer ersten Klebstoffschicht 11 beschichtet, wobei sich die Klebstoffschicht 11 auf der Flächenseite der ersten Kunststofffolie 4 befindet, die den Flachleitern 3 zugewandt ist. In der ersten Kunststofffolie 4 sind erste Aussparungen 6 ausgebildet, die sich über die gesamte Breite (y-Richtung) der ersten Kunststofffolie 4 erstrecken. Im Bereich der ersten Aussparungen 6 befinden sich auch keine Abschnitte der ersten Klebstoffschicht 11. Das ist darauf zurückzuführen, dass bei der Herstellung der ersten Aussparungen 6 mit Abschnitten der ersten Kunststofffolie 4 auch die dort aufgebrachten Abschnitte der Klebstoffschicht 11 entfernt worden sind. Aufgrund der ersten Aussparungen 6 liegen Bereiche 7 der Flachleiter 3 frei. Auf die freiliegenden Bereiche 7 der Flachleiter 3 sind SMD-Leuchtdioden 8 montiert (siehe insbesondere Fig. 4).

Die zweite Kunststofffolie 5 ist mit einer zweiten Klebstoffschicht 12 beschichtet, wobei sich die Klebstoffschicht 12 auf der Flächenseite der zweiten Kunststofffolie 5 befindet, die den Flachleitern 3 zugewandt ist. In der zweiten Kunststofffolie 5 sind zweite Aussparungen 9 ausgebildet, die sich von den Längskanten der zweiten Kunststofffolie 5 in Richtung der Flachleiter 3 (y-Richtung) erstrecken, diese aber nicht erreichen. Im Bereich der zweiten Aussparungen 9 befinden sich auch keine Abschnitte der Klebstoffschicht 12. Das ist darauf zurückzuführen, dass bei der Herstellung der zweiten Aussparungen 9 mit Abschnitten der zweiten Kunststofffolie 5 auch die dort aufgebrachten Abschnitte der zweiten Klebstoffschicht 12 entfernt worden sind. Aufgrund der zweiten Aussparungen liegen Bereiche 13 der ersten Klebstoffschicht 11 der gegenüberliegenden ersten Kunststofffolie 4 frei. Mit diesen freiliegenden Bereichen 13 der ersten Klebstoffschicht 11 ist das Flachleiterkabel 2 mit einem Träger 14 verklebt (siehe insbesondere Fig. 3).

Die ersten Aussparungen 6 sind äquidistant zueinander ausgebildet. Auch die zweiten Aussparungen 9 sind äquidistant zueinander ausgebildet. Die ersten Aussparungen 6 liegen mittig zu den zweiten Aussparungen 9. Es gibt keine Überlappungen zwischen den ersten Aussparungen 6 und den zweiten Aussparungen 9.

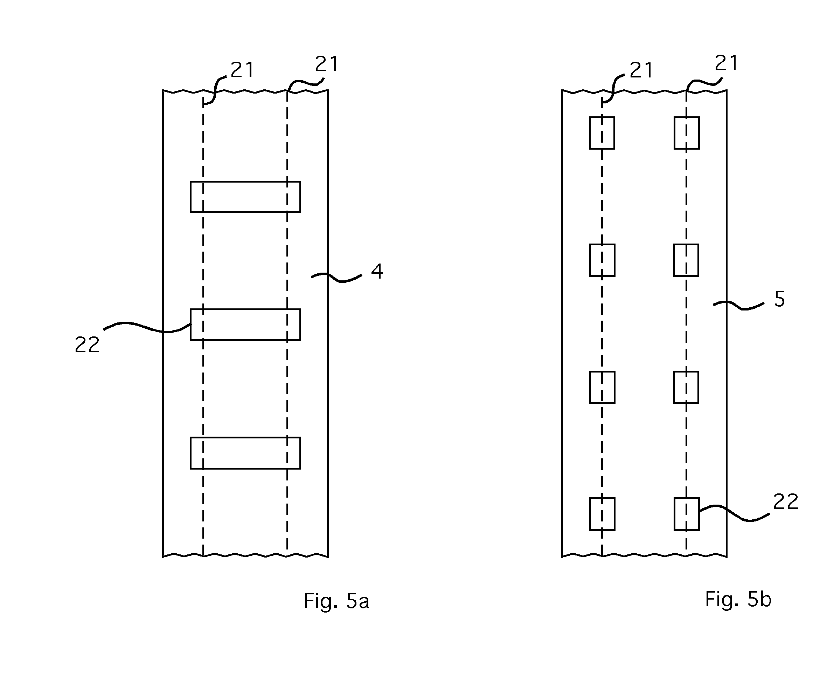

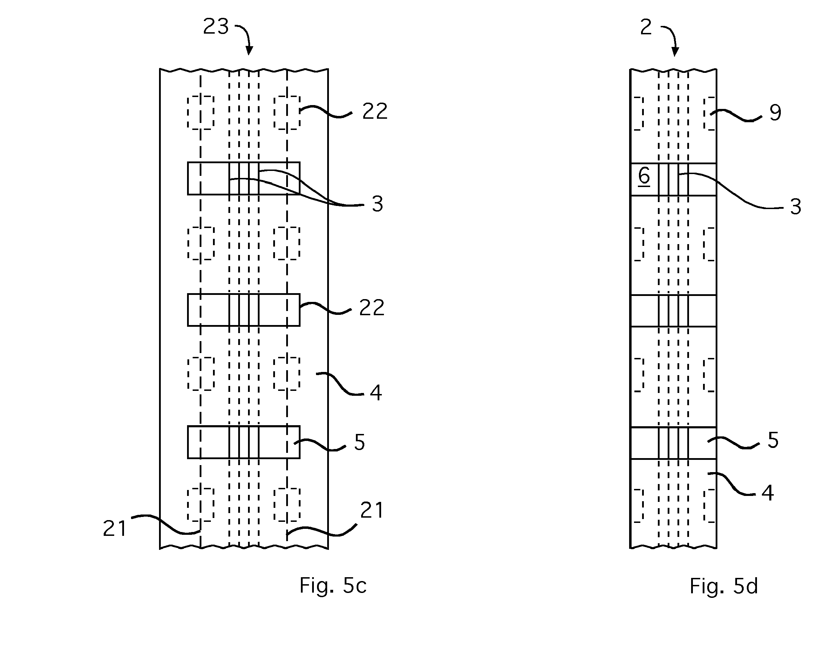

Ein Verfahren zur Herstellung des in den Figuren 1 bis 4 gezeigten Flachleiterkabels 2 ist in Fig. 5 gezeigt. Zuerst werden Kunststofffolien 4, 5 bereitgestellt, in die Fenster 22 eingebracht werden. Fig. 5a zeigt die erste Kunststofffolie 4 mit Fenstern 22, die nach dem Zuschneiden der Folie entlang der Schnittlinien 21 die ersten Aussparungen 6 bilden. Fig. 5b zeigt die zweite Kunststofffolie 5 mit Fenstern 22, die nach dem Zuschneiden der Folie entlang der Schnittlinien 21 die zweiten Aussparungen 9 bilden. Es ist in den Figuren 5a und 5b zu erkennen, dass die Fenster 22 nicht an den Längskanten der Kunststofffolien 4, 5 liegen. Die Kunststofffolien 4, 5 sind jeweils mit einer Klebstoffschicht 11, 12 (nicht gezeigt) beschichtet.

Fig. 5c zeigt die beiden Kunststofffolien 4, 5, nachdem diese miteinander verklebt worden sind, wodurch verklebte Kunststofffolien 23 erhalten werden. Zwischen den beiden Kunststofffolien 4, 5 liegen die Flachleiter 3. Die beiden Kunststofffolien 4, 5 sind mit ihren einander zugewandten Flachseiten miteinander so verklebt, dass die Klebstoffschichten 11, 12 zwischen den beiden Kunststofffolien 4, 5 liegen. Bei der in Fig. 5c gezeigten Darstellung der miteinander verklebten Kunststofffolien 23 liegt die erste Kunststofffolie 4 über der zweiten Kunststofffolie 5.

Fig. 5d zeigt das Flachleiterkabel 2, das aus dem in Fig. 5c gezeigten miteinander verklebten Kunststofffolien 23 durch Beschneiden der verklebten Kunststofffolien 23 an den Schnittlinien 21 erhalten wurde. Es ist zu erkennen, dass die ersten und zweiten Aussparungen 6, 9 nun an den Längskanten des Flachleiterkabels 2 liegen. Die ersten und zweiten Aussparungen 6, 9 werden aus den Fenstern 22 durch Zuschneiden erhalten.

### Bezugszeichenliste

- 1: Leuchtmittel
- 2: Flachleiterkabel
- 3: Flachleiter
- 4: erste Kunststofffolie
- 5: zweite Kunststofffolie
- 6: erste Aussparung
- 7: freiliegender Bereich eines Flachleiters
- 8: Leuchtdiode
- 9: zweite Aussparung
- 10: Kontakte
- 11: erste Klebstoffschicht
- 12: zweite Klebstoffschicht
- 13: freiliegender Bereich der ersten Klebstoffschicht
- 14: Träger
- 21: Schnittlinie
- 22: Fenster
- 23: verklebte Kunststofffolien

## Patentansprüche

1. Elektronisches Bauteil mit einem Träger (14), einem oder mehreren elektronischen Bauelementen (8) und einem Flachleiterkabel (2), das zumindest zwei parallel zueinander verlaufende Flachleiter (3) aus einem elektrisch leitfähigen Material aufweist, die zwischen einer ersten Kunststofffolie (4) und einer zweiten Kunststofffolie (5) angeordnet sind und mittels zumindest einer Klebstoffschicht (11, 12) mit diesen verklebt sind, wobei in der ersten Kunststofffolie (4) erste Aussparungen (6) unter Ausbildung freiliegender Bereiche (7) der Flachleiter (3) ausgebildet sind, auf die die elektronischen Bauelemente (8) montiert sind, **dadurch gekennzeichnet, dass** das Flachleiterkabel (2) mit seiner zweiten Kunststofffolie (5) auf dem Träger (14) aufliegt, wobei in der zweiten Kunststofffolie (5) zweite Aussparungen (9) unter Ausbildung freiliegender Bereiche (13) der zumindest einen Klebstoffschicht (11, 12) ausgebildet sind, über die das Flachleiterkabel (2) mit dem Träger (14) verklebt ist.

2. Bauteil nach Anspruch 1, **dadurch gekennzeichnet, dass** die zweiten Aussparungen (9) an den Längskanten der zweiten Kunststofffolie (5) ausgebildet sind.

3. Bauteil nach Anspruch 1 oder Anspruch 2, **dadurch gekennzeichnet, dass** die ersten Aussparungen (6) sich über die gesamte Breite der ersten Kunststofffolie (4) erstrecken.

4. Bauteil nach einem der vorstehenden Ansprüche, **dadurch gekennzeichnet, dass** die ersten Aussparungen (6) den zweiten Aussparungen (9) nicht gegenüberliegen.

5. Bauteil nach einem der vorstehenden Ansprüche, **dadurch gekennzeichnet, dass** die elektronischen Bauelemente unabhängig voneinander aus der Gruppe ausgewählt sind, die Widerstände, Kondensatoren, Quarze, Dioden, Leuchtdioden, Transistoren, Spulen sowie Kombinationen davon umfasst.

6. Flachleiterkabel, das zumindest zwei parallel zueinander verlaufende Flachleiter (3) aus einem elektrisch leitfähigen Material aufweist, die zwischen einer ersten Kunststofffolie (4) und einer zweiten Kunststofffolie (5) angeordnet sind und mittels zumindest einer Klebstoffschicht (11, 12) mit diesen verklebt sind, wobei in der ersten Kunststofffolie (4) erste Aussparungen (6) unter Ausbildung freiliegender Bereiche (7) der Flachleiter (3) ausgebildet sind, auf die elektronische Bauelemente (8) montiert sind, **dadurch gekennzeichnet, dass** das Flachleiterkabel (2) mit seiner zweiten Kunststofffolie (5) auf dem Träger (14) aufliegt, wobei in der zweiten Kunststofffolie (5) zweite Aussparungen (9) unter Ausbildung freiliegender Bereiche (13) der zumindest einen Klebstoffschichten (11, 12) ausgebildet sind, über die das Flachleiterkabel (2) mit dem Träger (14) verklebt ist.

7. Verfahren zur Herstellung eines elektronischen Bauteils gemäß einem der Ansprüche 1 bis 5, wobei das Flachleiterkabel (2) mittels einer zwischen der ersten und zweiten Kunststofffolie (4, 5) befindlichen Klebstoffschicht (11, 12) über die zweiten Aussparungen (9) in der zweiten Kunststofffolie (5) mit dem Träger (14) verklebt wird.

8. Verfahren nach Anspruch 7, **dadurch gekennzeichnet, dass** es die Schritte umfasst:
(a) Bereitstellen einer ersten Kunststofffolie, die mit einer ersten Klebstoffschicht beschichtet ist, und Einbringen von Fenstern für die ersten Aussparungen (6) in die erste Kunststofffolie (4);
(b) Bereitstellen einer zweiten Kunststofffolie, die mit einer zweiten Klebstoffschicht beschichtet ist, und Einbringen von Fenstern für die zweiten Aussparungen (9) in die zweite Kunststofffolie (5);
(c) Anordnen von Flachleitern (3) zwischen der ersten und der zweite Kunststofffolie (4, 5), wobei die erste und zweite Klebstoffschicht (11, 12) einander zugewandt sind, und Verkleben der beiden Kunststofffolien (4, 5) unter Bildung eines Flachleiterkabels (2); und
(d) Aufbringen des Flachleiterkabels (2) auf den Träger (14), so dass die zweite Kunststofffolie (5) auf dem Träger (14) aufliegt, unter Herstellen einer Klebverbindung zwischen dem Träger (14) und dem Flachleiterkabel (2).

9. Verfahren nach Anspruch 8, **dadurch gekennzeichnet, dass** es ferner die Montage von elektronischen Bauelementen (8) auf die freiliegenden Bereiche (7) der Flachleiter (3) umfasst.

10. Verfahren nach Anspruch 9, **dadurch gekennzeichnet, dass** die elektronischen Bauelemente (8) im Anschluss an Schritt (c) oder im Anschluss an Schritt (d) montiert werden.

11. Verfahren nach einem der Ansprüche 7 bis 10, **dadurch gekennzeichnet, dass** Schritt (c) ferner das Bescheiden der verklebten Kunststofffolien (23) an ihren Längsrändern unter Ausbildung der ersten und zweiten Aussparungen (6, 9) umfasst.
